Europäisches Patentamt

European Patent Office

Office européen des brevets

(11) Publication number: 0 569 114 A2

## EUROPEAN PATENT APPLICATION

(21) Application number: 93300978.9

(22) Date of filing: 11.02.93

(51) Int. Cl.5: H03K 17/56

(30) Priority: 06.05.92 GB 9209788

(43) Date of publication of application:
10.11.93 Bulletin 93/45

(84) Designated Contracting States:
DE FR GB

(71) Applicant: International Business Machines
Corporation
Old Orchard Road
Armonk, N.Y. 10504(US)

(72) Inventor: Morrish, Andrew John

1185 Happy Valley Avenue
San Jose, California 95129(GB)
Inventor: Eagle, David John
24 Whitelea Crescent,
Kilmacolm
Renfrewshire PA13 4JP, Scotland(GB)

(74) Representative: Burt, Roger James, Dr.
IBM United Kingdom Limited
Intellectual Property Department
Hursley Park
Winchester Hampshire SO21 2JN (GB)

(54) Switch circuit.

(57) A switch circuit comprises a first field effect transistor (FET) (Q1') connected in series with a bipolar transistor (BJT) (Q2') to form a first closable current path between first and second conductors. A second FET (Q3') is connected across the base-collector junction of the BJT to form a second closable current path between the first conductor and the base of the BJT (Q2') for supplying current to the base of the BJT (Q2') from the first conductor. A control conductor is connected to the gates of the first and second FETs (Q1',Q3') for opening the first and second current paths in response to an input voltage. Means (D1,D2) is provided for discharging current from the base of the BJT (Q2') to the second conductor to close the first current path upon removal of the input voltage.

EP 0 569 114 A2

FIG. 2

EP 0 569 114 A2

The present invention relates to a switch circuit for high speed, high power applications

Fast, high power switch circuits are used in many electrical appliances. For example, such switch circuits are included in Switch Mode Power Supplies for raster-scanned visual display units and the like. In a raster-scanned visual display unit, the switch circuit in the switch mode power supply is usually synchronised in operation to the horizontal scan frequency to reduce front-of-screen interference. Such visual display units are increasingly required to operate at higher scan frequencies. However, an increase in the horizontal scan frequency produces a corresponding increase in the power supply switching frequency and therefore a corresponding increase in switching loss from the switch circuit. The switching loss can be minimised by minimising the transition time between on and off states of the switch circuit.

A conventional fast, high power switch circuit for a switch mode power supply typically comprises a high power field effect transistor (FET) with it's drain connected to the emitter of a Bipolar Junction Transistor (BJT) in an emitter switching configuration. The base of the BJT is connected to a voltage source via a resistor. The switch circuit is controlled by an input voltage applied to the gate of the FET. When the input voltage exceeds the threshold voltage of the FET, the FET turns on. The emitter of the BJT is thus pulled down and the base of the BJT draws current from the voltage source via the resistor. The BJT is thus turned on to open a current path through the BJT and the FET. When the input voltage returns to below the threshold voltage, the FET rapidly turns off. Current now flows from the collector of the BJT out of it's base. Therefore the BJT rapidly turns off. The BJT must receive enough base current from the voltage source to saturate over a range of current gains. However, sufficient base current can incur high power losses from the voltage source. Furthermore, complex circuitry is required to make available sufficient base current to operate the switch circuit when the switch mode power supply is initially turned on.

In accordance with the present invention, there is now provided a switch circuit comprising: a BJT; a first FET connected in series with the BJT to form a first closable current path between first and second conductors; a second FET connected across the base-collector junction of the BJT to form a second closable current path between the first conductor and the base of the BJT for supplying current to the base of the BJT from the first conductor; a control conductor connected to the gates of the first and second FETs for opening the first and second current paths in response to an input voltage; and means for discharging current from the base of the BJT to the second conductor to close the first current path upon removal of the input voltage.

Because the base current to the BJT is provided from the current path controlled by the switch circuit, and is buffered from the control conductor by the gates of the FETs, the present invention advantageously provides a switch circuit with a high input impedance. Therefore, complex circuitry for initially supplying base current to the BJT is not required.

Furthermore, because the base of the BJT is connected to the channel of the second FET, when the second FET initially turns on, its parasitic capacitances are discharged into the base of the BJT to advantageously aid fast turn on.

Still furthermore, because the base current supplied to the BJT is dependent on the voltage across the BJT, the base current to the BJT is advantageously optimised by a feedback loop that operates to minimise both conduction loss and turn on time. Specifically, the larger the voltage drop across the BJT, the greater the base current flowing through the second FET into the base of the BJT. The greater the base current flowing into the base of the BJT, the harder the BJT is driven into saturation.

The means for discharging current from the base of the BJT advantageously permits rapid turn off of the switch circuit. In an advantageously low cost example of the present invention, the discharge means includes a pair of diodes connected in series in a forward biased configuration from the base of the BJT to the second conductor.

Preferably, the first FET has a relatively low on resistance to minimise conduction loss. However, advantageously, the first FET may be a low voltage device because it never has more than a few volts placed across it.

Because the first and second conductors are connected to channel electrodes of FETs, the present invention advantageously provides a switch circuit having a high output impedance a kin to a single FET and therefore advantageously provides a switch circuit particularly, although not exclusively, suitable for switch mode power supply designs. It will be appreciated that the present invention extends to a switch mode power supply comprising such a switch circuit. It will also be appreciated that the present invention provides a switch circuit that may be formed from discrete components or from devices fabricated on a single semiconductor substrate. It will therefore be appreciated that the present invention extends to an integrated circuit comprising such a switch circuit.

2

A preferred embodiment of the present invention will now be described with reference to the accompanying drawings in which:

Figure 1 is a circuit diagram of a conventional switch circuit;

Figure 2 is a circuit diagram of a switch circuit of the present invention; and

Figure 3 is a current waveform diagram corresponding to a switch mode power supply comprising a switch circuit of the present invention.

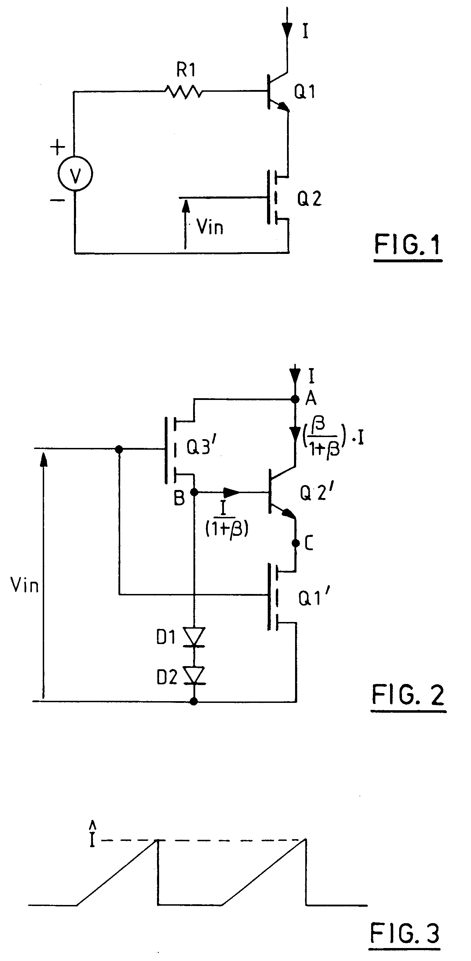

Referring first to Figure 1, a conventional switch circuit comprises a power FET Q2 with its drain connected to the emitter of a BJT Q1 in an emitter switching configuration. The base of Q1 is connected via a resistor R1 to a voltage source V. In operation, the source of Q2 is held at 0V and the switch circuit is controlled by an input voltage Vin applied to the gate of Q2. When Vin exceeds the threshold voltage, Vt, of Q2, Q2 turns on. The emitter of Q1 is thus pulled down and the base of the Q1 draws current from the voltage source in V via the resistor R1. Q1 is thus turned on and current flows between the emitter and collector of Q1 and between the drain and source of Q2. When Vin returns to below Vt, Q2 turns off. Current now flows from the collector of Q1 out through the base of Q1. Therefore Q1 rapidly turns off.

Referring now to Figure 2, an example of switch circuit of the present invention comprises a power FET Q1' with it's drain connected at node C to the emitter of a BJT Q2'. The base of Q2' is connected at node B to the source of a power FET Q3'. The drain of Q3' is connected at node A the collector of Q2'. The gates of Q1' and Q3' are connected together. Node B is connected to the source of Q1' by forward biased diodes D1 and D2.

In operation, the source of Q2' is held at 0V and the switch circuit is controlled by an input voltage Vin applied to the gates of Q1' and Q3'. Assuming that the switch circuit is initially turned off, Q3' and Q1' turn on very quickly in response to an input voltage Vin of 10V, for example. The voltage on node C therefore becomes lower than the voltage on node B. The base-emitter junction of Q2' is thus forward biased. Therefore, Q2' starts to turn on, fed with base current from Q3'. When Q3' initially turns on, it's parasitic capacitances are discharged. Therefore the base of Q2' receives a rapid injection of charge that advantageously aids fast turn on. Current then flows between the collector and emitter of Q2' and between the source and drain of Q1' and the total voltage drop across the switch circuit is the sum of the individual voltage drops across Q1' and Q2'.

The larger the voltage drop across Q2', the greater the base current flowing through Q3' into the base of Q2'. The greater the base current flowing into the base Q2', the harder Q2' is driven into saturation. This feedback loop advantageously optimises the base drive current supplied to Q2'.

Preferably, Q1' has a very low on resistance. However, there is advantageously no need for Q1' to be a high voltage device because it never has more than a few volts to placed across it.

To turn the switch circuit off, Vin is reduced to 0V. This rapidly turns off Q1' and Q3'. Current flows out of the base of Q2' through D1 and D2. Q2' is therefore very quickly turned hard off. It will be appreciated that D1 and D2 may be replaced in other embodiments of the present invention by, for example, a zener diode.

What follows is an analysis of the power dissipated by the switch circuit in operation. For the purposes of the analysis, Rds1 = Rds on of Q1', B = current gain of Q2', Vbe2 = Vbe of Q2', and Rds3 = Rds on of Q3'.

Voltage at node A:

$$V = I \cdot Rds1 + Vbe2 + \frac{I}{(1+\beta)} \cdot Rds3 \qquad (1)$$

$$Hence \ Power = I^2 \cdot (Rds1 + Rds3) + \frac{I \cdot Vbe2}{(1+\beta)} \qquad (2)$$

With reference to Figure 3, what follows is an analysis of the average power dissipated by the switch circuit when switching, with a 1/3 duty cycle, the current flowing in the primary winding of the transformer of a discontinuous switch mode flyback power supply.

EP 0 569 114 A2

Typically a duty cycle or 1/3 or less is used. Assume 1/3:

$$\text{Average power} = \frac{1}{3} \cdot \frac{1}{\hat{I}} \int_0^{\hat{I}} I^2 \left( Rds1 + \frac{Rds3}{(1+\beta)} \right) + I \cdot Vbe2 \cdot dI$$

$$= \frac{1}{3\hat{I}} \left[ \frac{\hat{I}^3}{3} \left( Rds1 + \frac{Rds3}{(1+\beta)} + \frac{\hat{I}^2}{2} \cdot Vbe2 \right) \right] \quad (3)$$

$$= \frac{\hat{I}^2}{9} \left( Rds1 + \frac{Rds3}{(1+\beta)} \right) + \frac{\hat{I}}{6} \cdot Vbe2$$

Extending this formula indicates that, if the switch mode power supply comprises a transformer with a primary inductance of 111uH, to produce 120W at 60kHz from 120V DC with a duty cycle 1/3, a peak current of 6A is required.

Typical values for the parameters Rds1, B, Rds3, and Vbe2 are 0.1ohms, 10, 4ohms, and 1.0V respectively. Therefore, from the above equations, the total power dissipation from the circuit is 2.85W. Of this, 0.13W is dissipated by Q3', 0.4W is dissipated by Q1', and 2.32W is dissipated by Q2'.

The above analysis concerns conduction losses only. It will however be appreciated that there will also be some switching losses. However, these losses will be comparatively small because of the fast switching action.

To achieve similar conduction losses using the conventional switch circuit concept shown in Figure 1 would require as many as five or six conventional power FETs connected in parallel. In practice, this would complicate assembly and increase cost. Furthermore, the large total gate capacitance would introduce difficulty in providing a suitable drive signal.

It will be appreciated from the foregoing that a switch mode flyback power supply comprising a switching circuit of the present invention may supply significantly more power than a practical switch mode flyback power supply of conventional design. Therefore, in the past, alternative power supply designs have, in general, been adopted where the demanded power has been in excess of 200W. It will therefore be appreciated that the present invention advantageously extends the useful range of conventional switch mode flyback power supplies.

It will further be appreciated that the switch circuit of the present invention hereinbefore described may be formed from discrete components or fabricated in the form of a 3 pin integrated circuit package.

**Claims**

1. A switch circuit comprising: a bipolar transistor (Q2'); a first field effect transistor (Q1') connected in series with the bipolar transistor (Q2') to form a first closable current path between first and second conductors; a second field effect transistor (Q3') connected across the base-collector junction of the bipolar transistor (Q2') to form a second closable current path between the first conductor and the base of the bipolar transistor (Q2') for supplying current to the base of the bipolar transistor (Q2') from the first conductor; a control conductor connected to the gates of the first and second field effect transistors (Q1' ,Q3') for opening the first and second current paths in response to an input voltage; and means (D1,D2) for discharging current from the base of the bipolar transistor (Q2') to the second conductor to close the first current path upon removal of the input voltage.

2. A switch circuit as claimed in claim 1 wherein the discharging means comprises at at least one diode connecting the base of the bipolar transistor to the second conductor in a forward biased configuration.

3. A switch circuit as claimed in claim 1 wherein the discharging means comprises a zener diode connecting the base of the bipolar transistor to the second conductor in a forward biased configuration.

4. An integrated circuit comprising a switch circuit as claimed in any preceding claim.

4

5. A power supply comprising a transformer, and a switch circuit as claimed any preceding claim for switching current in the primary winding of the transformer.

FIG.1

FIG. 2

FIG. 3